# EUROPEAN PATENT APPLICATION

(11) **EP 1 926 145 A2**
(43) Date of publication of application: **28.05.2008**
(21) Application number: 07120722.9
(22) Date of filing: 14.11.2007
(51) Int. Cl.: H01L 25/065

(54) **Self-aligned through vias for chip stacking**

(30) Priority: 21.11.2006 US 602536
(71) Applicant: Qimonda North America Corp., Cary, NC 27513 (US)
(72) Inventor: Sitaram Arkalgud, Cedar Park, TX 78613 (US)
(74) Representative: Epping - Hermann - Fischer

(57) **Abstract**

An electronic component includes a first component and a second component, each having a surface that includes a plurality of exposed contacts separated by an insulating material. A sandwich layer is disposed between the surface of the first component and the surface of the second component. The surface of the first component is then attached to the surface of the second component with the sandwich layer therebetween. The sandwich layer forms conductive areas between contacts of the first component and contacts of the second component and forms an insulator between the conductive areas.

## Description

### TECHNICAL FIELD

This invention relates generally to interconnected electronic components and, in specific, embodiments to self-aligned through-vias for chip stacking.

### BACKGROUND

One of the goals in the fabrication of electronic components is to minimize the size of various components. For example, it is desirable that hand held devices such as cellular telephones and personal digital assistants (PDAs) be as small as possible. To achieve this goal, the semiconductor circuits that are included within the devices should be as small as possible. One way of making these circuits smaller is to stack the chips that carry the circuits.

A number of ways of interconnecting the chips within the stack are known. For example, bond pads formed at the surface of each chip can be wire-bonded, either to a common substrate or to other chips in the stack. Another example is a so-called micro-bump 3D package, where each chip includes a number of micro-bumps that are routed to a circuit board, e.g., along an outer edge of the chip.

Yet another way of interconnecting chips within the stack is to use through-vias. Through-vias extend through the substrate thereby electrically interconnecting circuits on various chips. Through-via interconnections can provide advantages in terms of interconnect density compared to other technologies. While there is, in theory, no limit as to the number of chips that can be stacked, the ability to remove heat from inside the stack can limit the number of chips as a practical matter.

During the stacking of chips on each other, it is important that the through-vias and bond pads on the chips are aligned. Misaligned vias and bond pads can result in degraded electrical conductivity, poor reliability and even the absence of electrical connections and functionality between layers.

Conventionally, correctly aligned features are ensured by specifying fine alignment tolerances. This can result in increased cost due to more expensive equipment and/or lower throughput. This problem gets exacerbated when very fine pitch vias are used, since the alignment tolerance requirement becomes even more critical. However, being able to bond dies with fine pitched vias accurately and reliably can be a huge competitive advantage, both in terms of cost and performance.

As a result, what is needed is a way of improving the alignment tolerance of through-vias in 3D chip stacking.

### SUMMARY OF THE INVENTION

An electronic component includes a first component and a second component, each having a surface that includes a plurality of exposed contacts separated by an insulating material. A sandwich layer is disposed between the surface of the first component and the surface of the second component. The surface of the first component is then attached to the surface of the second component with the sandwich layer therebetween. The sandwich layer forms conductive areas between contacts of the first component and contacts of the second component and forms an insulator between the conductive areas.

The details of one or more embodiments of the invention are set forth in the accompanying drawings and the description below. Other features, objects, and advantages of the invention will be apparent from the description and drawings, and from the claims.

### BRIEF DESCRIPTION OF THE DRAWINGS

For a more complete understanding of the present invention, and the advantages thereof, reference is now made to the following descriptions taken in conjunction with the accompanying drawings, in which:
Figures 1A and 1B are cross-sectional views illustrating the goal of stacking components;
Figures 2A and 2B illustrate cross-sectional views of a first embodiment of the invention;
Figures 3A and 3B illustrate cross-sectional views of a second embodiment of the invention;
Figure 4 illustrates a cross-sectional view of a second embodiment of the invention;
Figure 5 illustrates a cross-sectional view of a stack of three components;
Figures 6A and 6B illustrate cross-sectional views of an alternate embodiment of the invention;
Figure 7 is a flow chart of a process to form a semiconductor device; and
Figures 8A and 8B illustrate an embodiment that implements a redistribution layer.

### DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

The present invention will be described with respect to preferred embodiments in a specific context, namely a stack of semiconductor chips interconnected by through-vias. The invention may also be applied, however, to other interconnected components. For example, a chip or chips can be coupled to a board. In another example, components other than semiconductors can be used.

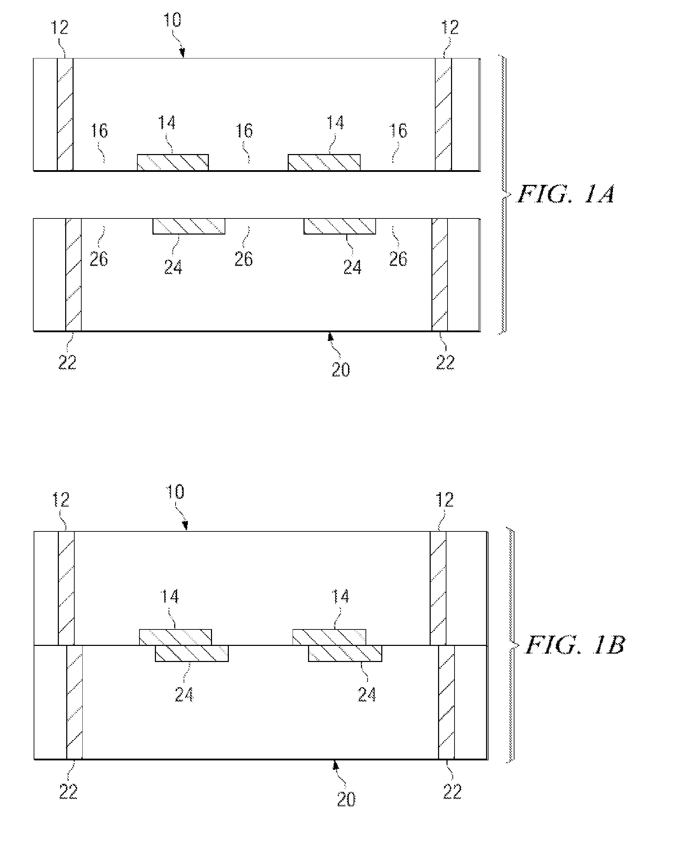

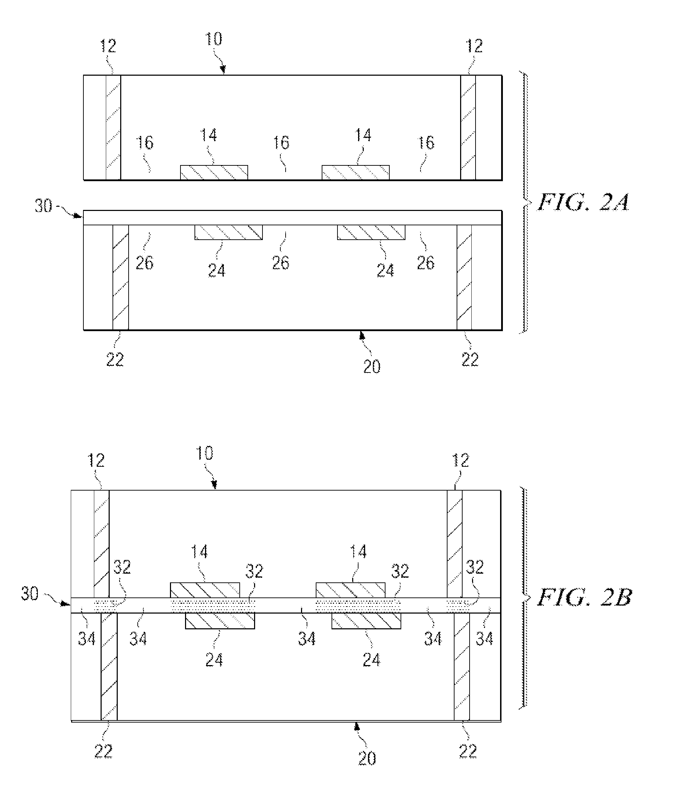

A first embodiment will now be described with respect to Figures 1A, 1B, 2A and 2B. Figures 1A and 1B illustrate the goal of trying to electrically interconnect two components when alignment is an issue. Figures 2A and 2B provide a solution to that problem.

Referring first to Figure 1A, a first component 10 and a second component 20 are shown. Each component 10 (20) includes through-vias 12 (22) and pads 14 (24), which can both be referred to as contacts. The contacts are separated from one another by insulating material 16 (26). The goal is to electrically and physically connect the two components 10 and 20 so that the contact areas 12 and 14 of the first component 10 are electrically coupled to the contact areas 22 and 24 of the second component 20. As shown in Figure 1b, the electrical connection can be problematic when alignment of the two components is difficult.

In the preferred embodiment, the components 10 and 20 semiconductor components, e.g., wafers or chips (dies). For example, both components 10 and 20 can be semiconductor wafers, e.g., wafer-on-wafer stacking, or both components can be chips, e.g., chip-on-chip stacking. In another example, one component is a wafer while the other component is a chip, e.g., chip-on-wafer stacking. The following discussion applies equally to each of these combinations.

Further, it is noted that the drawings are provided for simplistic illustration of concepts of the present invention. It is understood that many more than two vias 12/22 and/or pads 14/24 will be included in a typical integrated circuit. Further, these contacts will not typically cover the entire surface area of the chip, although they certainly could. In many device configurations, the vias and pads are formed in the periphery of the chip (e.g., for logic components) or in the center of the chip (e.g., for memory components such as dynamic random access memories).

Figures 2A and 2B illustrate a first embodiment that can solve the problem of misalignment of the electrical connections. As shown in Figure 2A, a thin layer of material 30 is included between the components 10 and 20. In the preferred embodiment, the material has the property of being able to react with the conductor in the vias 12/22 and pads 14/24 to form a self-aligned, conducting intermetallic. The material also preferably reacts with the dielectric 16/26 to form an electrically insulating compound. Ideally, the electrically insulating compound is also thermally conductive, so that heat generated by the components 10/20 can be removed. The thin layer of material can typically be formed to a thickness of between about 2 nm and 250 nm, preferably about 10 nm.

In the embodiment of Figure 2A, the thin layer of material 30, which can be referred to as a sandwich layer 30, is formed only on the second component 20. This arrangement is not required. For example, when the two chips are identical, e.g., for stacked memories, it is often advantageous that all components be the same, for example to simplify inventory requirements. As a result, the sandwich layer 30 can be formed on both components.

Referring now to Figure 2B, the first and second components are joined together so that top surface of the first component is attached to the top surface of the second component 20 with the sandwich layer 30 in between. The sandwich layer 30 can then be reacted to form self-aligned local interconnects 32 between the contacts 12/14 of the first component and the contacts 22/24 of the second component. These interconnects 32 are isolated from one another by the insulating material 34, which was also formed from the sandwich layer. This process ensures a high conductivity contact between even severely misaligned fine pitch vias.

To form the self-aligned local interconnects (and intervening insulating material), the components are typically heated while in contact. It is desirable that the material 30 not require very high temperatures for the formation of the conducting 32 and insulating 34 compounds. For example, the sandwich layer can be heated at a temperature not greater than about 400 °C, preferably between about 250 °C and about 350 °C.

Titanium is one example of a material that can be used for the sandwich layer 30. Titanium is very reactive and is commonly used to form silicides and glue layers. In the case of semiconductor components, titanium will react with polysilicon, aluminum, copper or tungsten contacts to create the conductive interconnects 32. It will also react with typical passivation layers such as silicon dioxide or silicon nitride to create titanium oxides, oxynitrides and silicates. As additional examples, the sandwich layer material can be other metals such as tantalum or other materials such as conductive polymers, manganese, platinum, magnesium or copper.

Of the types of stacked chips which can be formed, one example would be to stack several memory chips on each other. The chips could be DRAM, SRAM, NAND or NOR Flash chips or any combination of these dictated by the product application. In the case of memory chips, the metallization and contact material could be aluminum, the passivation layers could be silicon dioxide and silicon nitride, the sandwich layer could be titanium and the isolation material could be silicon dioxide or a polymer such as benzocyclobutene (BCB).

In another example, a logic chip such as a microprocessor or a digital signal processor (DSP) could be stacked with other chips such as memory or analog chips. In such a case, the metallization material could include copper and tantalum layers, whereas the other layers could be the same as before. In a third example, a CMOS chip (logic or memory) could be combined with a non-CMOS component such as a MEMS or a biosensor device. In such a case, the metallization material could also include a conductive paste such as solder. The other materials would remain similar to the two examples above.

In the embodiments described thus far, the sandwich layer 30 interacts with both the conductors 12/14/22/24 and the insulators 16/26. This feature is not necessary. If the material 30 is a conductor 32 as deposited, then it only needs to react with the insulator 16/26 to become an insulator 34. Likewise, if the material 30 is an insulator 34 as deposited, then it only needs to react with the conductors 12/14/22/24 to become a conductor 32.

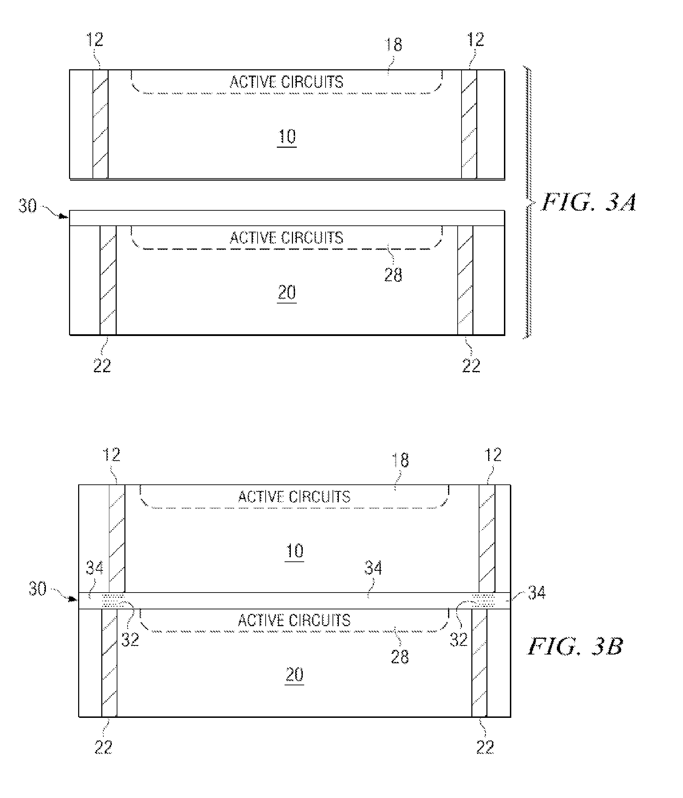

In the case where the components 10 and 20 are aligned in a face-to-face manner, as illustrated in Figure 2, the insulating material 16 is formed as part of the process. In the case of a back-to-face scheme, as illustrated in Figure 3 as an example, a backside isolation layer can be added.

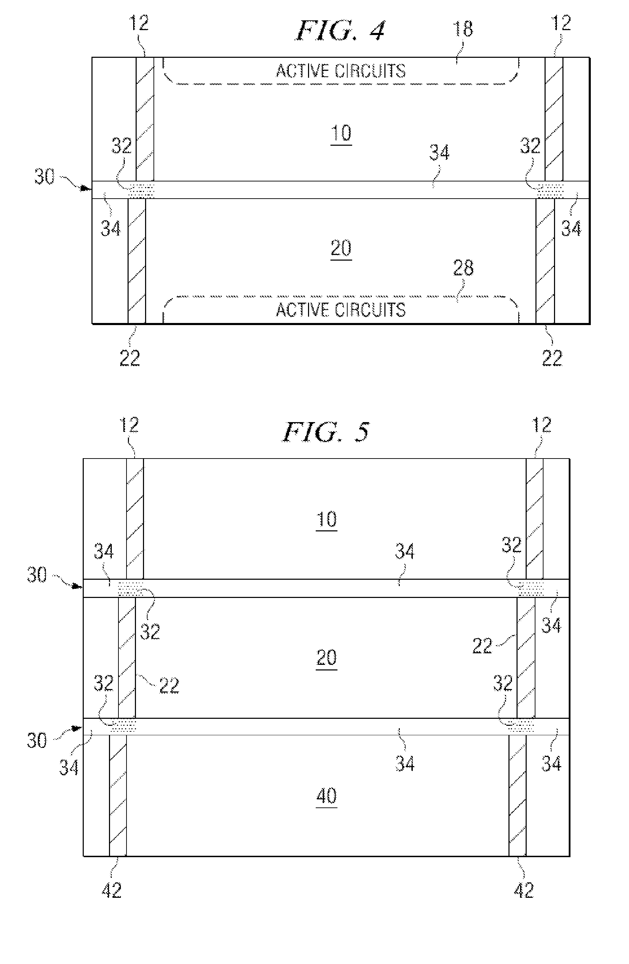

Figure 3, which includes Figures 3A and 3B, and Figure 4 are provided to illustrate two alternative configurations. In the embodiment of Figure 2, the components 10 and 20 were attached face-to-face, that is the front-side surface of component 10 was attached to the front-side surface of component 20. In the case of a semiconductor chip (wafer), the front-side is the side that includes the active circuitry (e.g., transistors).

Figures 3A and 3B illustrate the example where the active-side surface of the second component 20 is attached to the back-side surface of the first component 10. The active-side surface is denoted in these figures by the inclusion of the region 18 (28), which is labeled "active circuits." This configuration is desirable when identical components are being used since the through-vias will naturally line-up, thus avoiding the need for redistribution layers, customization of chips for the top and bottom, or careful design of via placement. Figure 4 illustrates the example where the chips are aligned back to back.

In the example illustrated in Figure 3A, the sandwich layer 30 is formed only on the front-side surface of the second component 20. If a sandwich layer is a conductor and is also included on the front-side surface of the first component 10, then the first component 10 would need to be modified before the assembly is complete so that the contacts 12 (and 14, if included) are not all shorted out. For example, component 10 can be modified by removing the layer 30, e.g., by etching, or by reacting the layer 30 to form insulators in the desired portions. If the sandwich layer is initially an insulator, it can be selectively etched, e.g., by patterning, to expose to contacts. In other cases, the insulating sandwich layer 30 can remain over the contacts, e.g., in the case where wire bonding, which can connect through a thin insulator, is used.

A typical semiconductor chip includes a silicon (or other semiconductor) back-side surface. Unless the layer 30 can react with silicon to create an insulator, an additional material will be added. Accordingly, Figure 3A shows that the component 10 includes a backside insulating layer 31. While only illustrated with the top component, it is likely that convenience would dictate including this region 31 on all components. The layer 31, which can be an oxide or a polymer as examples, can be deposited. In another example, an oxide layer can be thermally grown. In the case of an SOI device, the layer 31 can be the buried oxide (or other insulator), which will be exposed when the substrate is grinded back.

Figure 4 provides another alternative embodiment. In this case, the components 10 and 20 are arranged back-to-back. For example, one of the components 10 or 20 could include a sandwich layer 30 on the front side while the other component 20 or 10 includes a backside layer 31 on the backside. One example of this type of configuration is where more than two chips are stacked, with some face-to-face.

The concepts of the present invention are not limited to the stacking of only two components. Figure 5 illustrates an example where three components, labeled 10, 20 and 40 are stacked. In other embodiments, four, five, six or more components can be stacked. Figure 5 has been intentionally illustrated as being generic as to how the chips are stacked. These chips can be stacked back-to-front or front-to-front (or back-to-back) in pairs.

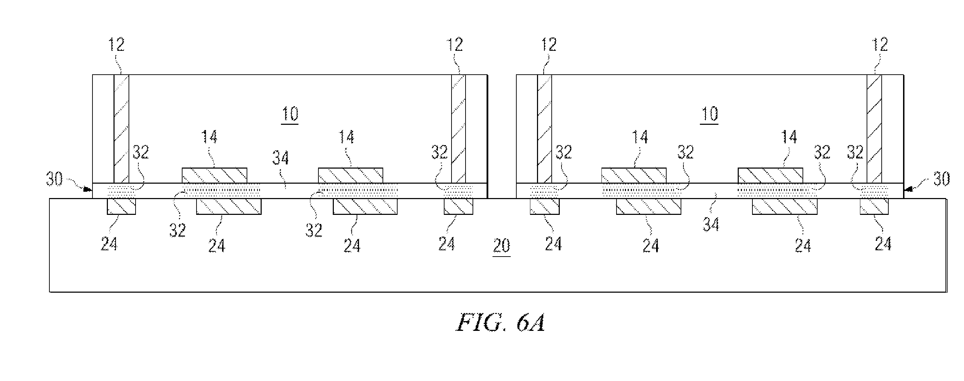

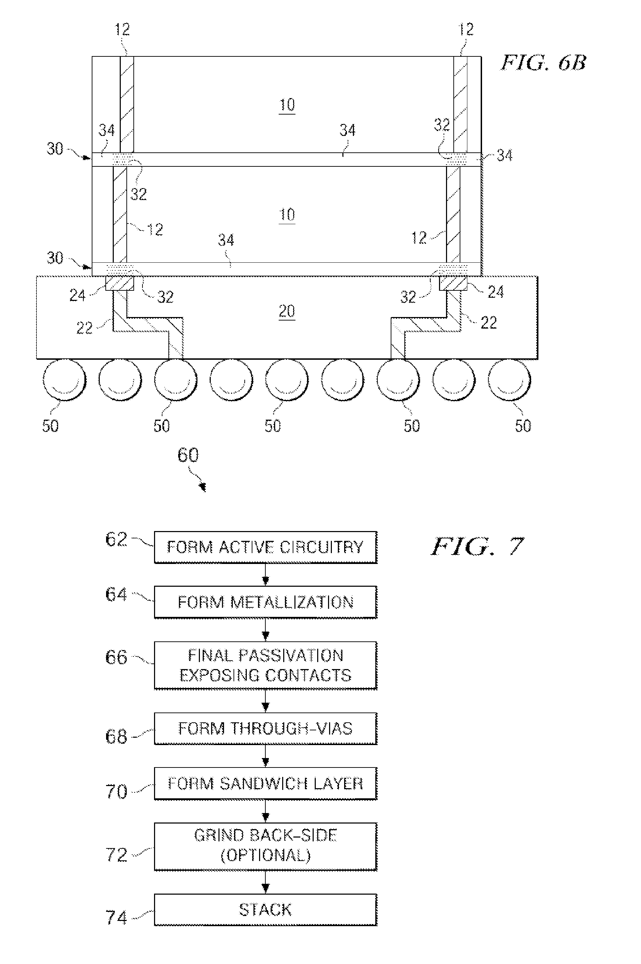

Thus far, the invention has been described only in terms of stacking of semiconductor components. In other embodiments, other components can be stacked. For example, the first component 10 can be a semiconductor chip 10 while the second component 20 is a board. Examples of this type of configuration are illustrated in Figures 6A and 6B. Variations and combinations of these examples are also possible.

Referring first to Figure 6A, the first component is a semiconductor chip 10 and the second component is a board 20. In this example, two chips 10 are mounted on the same board 20. Other variations are also possible. The entire assembly can be encapsulated if desired.

Figure 6B illustrates an example where two chips 10 are mounted upon each other (either face-to-face or in any other configuration). The stacked assembly is then mounted on a board 20. The board 20 includes pads 24 and through-vias 22, which in this case include horizontal interconnects. As a point of illustration, solder balls 50 are included on the surface of component 20 that is opposite of where the stack is mounted. Combinations of the embodiments of Figure 6A and 6B are also envisioned. For example, stacks of chips can be mounted side-by-side on a single board. Connection to the board can be as described herein or by conventional methods such as adhesives and wire bonds or conductive bumps.

In the preferred embodiment, at least one, if not both, of the stacked components are semiconductor chips. The fabrication of these chips will now be described with respect to the flow chart 60 of Figure 7.

As illustrated by box 62, active circuitry is formed at a surface of a semiconductor wafer. The circuitry can include transistors, resistors, capacitors, inductors or other components used to form integrated circuits. For example, active areas that include transistors (e.g., CMOS transistors) can be separated from one another by isolation regions, e.g., shallow trench isolation. This processing can be referred to as front-end or front end of line (FEOL).

As illustrated by box 64, the components formed during the front-end processing can then be interconnected by metallization, sometimes referred to as back end of line (BEOL). Metallization is formed over the active circuitry and in electrical contact with the active circuitry. The metallization and active circuitry together form a completed functional integrated circuit. In other words, the electrical functions of the chip can be performed by the interconnected active circuitry. In a logic chip, the metallization may include many layers, e.g., nine or more, of copper. In other devices, such as DRAMs, the metallization may be aluminum. In other examples, other materials can be used. In fact, the metallization need not actually be metal if other conductors are used.

Referring now to box 66, a final passivation layer is formed over the metallization layer. The final passivation layer can include more than one layer of material, the topmost layer being interactive with the sandwich layer, if desired. Examples of materials that can be used for the final passivation layer are silicon dioxide and silicon nitride. The final passivation layer includes openings to expose the contact areas.

The formation of the through-vias is illustrated by box 68. A plurality of through-vias can be formed through the semiconductor wafer, e.g., extending from the front-side surface to the back-side surface or extending deep enough to be exposed after the backside grinding (box 72). For example, via holes are etched to a depth of about 10µm to about 100µm. These holes are then lined with an insulator, such as an oxide or a polymer. After forming a barrier (e.g., Ta, TaN, Ta/TaN, Ti, TiN, Ti/TiN, as examples), a copper seed layer is formed followed by plated copper. Other processes and/or materials could alternatively be used. The through-vias are electrically coupled to the contact areas.

The sandwich layer 30 can then be formed over the final passivation layer and the exposed contacts, as shown by box 70. In one example, a blanket layer of conductive material is deposited over the final passivation layer and over the exposed contact area. This material may be any of the materials discussed above.

Optionally, the wafer may be thinned from the back-side, e.g., through grinding, as indicated by box 72. The advantage of thinning the wafer (or chip, if the wafer has already been singulated) is to create a lower profile component and to shorten the length of the through-vias, which enhances the electric properties. In addition, when the wafer is thinned, the through-vias can be formed by etching via holes down to a depth less than the thickness of the wafer, which saves processing time.

Box 74 is provided to indicate that the completed component can then be stacked with other components. This process can be performed as described above.

In each of the embodiments discussed above, the interconnects 32 are formed in a self-aligned manner. In this process, the two contacts to be electrically connected should overlap at least a small amount. Small misalignments are tolerable. In other situations, it is desirable to electrically connect contact areas that are not close to one another. For example, this technique is very useful when using different types of chips. For example, a memory chip or chips can be stacked with a controller chip.

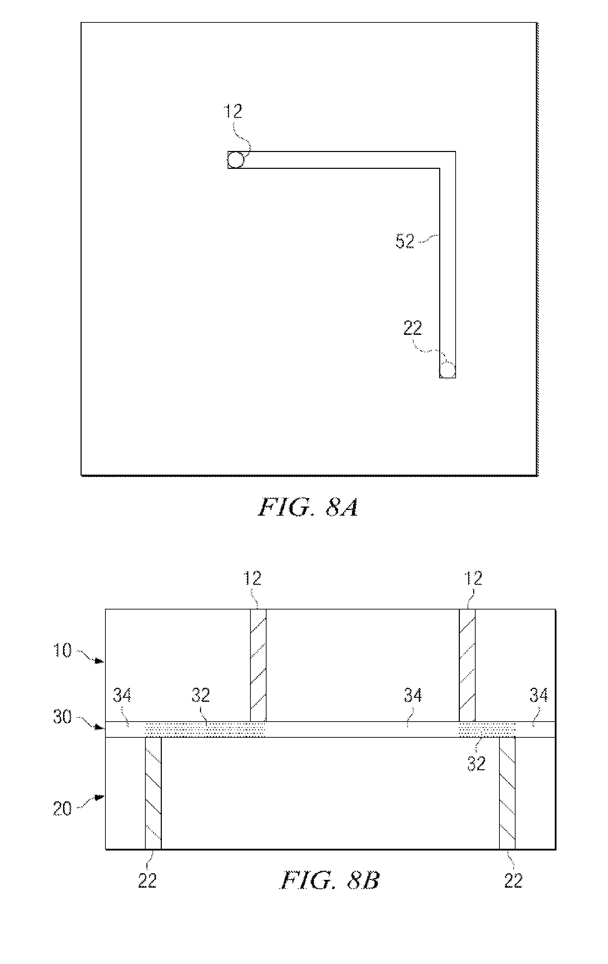

In an extension of concepts of the present invention, it is possible to form a redistribution layer. In this case, a material that reacts with the previous layer to form a conducting compound is deposited prior to the deposition of the sandwich layer 30. The second layer is then patterned to form the redistribution wiring scheme. Figure 8A illustrates the patterned redistribution layer 52. In this case, the redistribution layer 52 connects a via 12 of the first component with a via 22 of a second component. This figure shows one arbitrarily drawn redistribution line. It is understood that a number of lines would be used in a typical implementation.

Figure 8B shows an exemplary cross-section (which does not match up with the plan view of Figure 8A.) After formation of the redistribution line 52, the sandwich layer is deposited as discussed above. In other words, the sandwich layer overlies the redistribution line 52. The two components 10 and 20 can be then bonded as discussed above. In this case, the sandwich layer 30 will react with the redistribution line 52 to form the interconnects 32.

Any of the embodiments discussed above can be implemented using the redistribution scheme discussed here.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method of forming an electronic component, the method comprising:
providing a first component having a surface that includes a plurality of exposed contacts separated by an insulating material;
providing a second component having a surface that includes a plurality of exposed contacts separated by an insulating material;
disposing a sandwich layer between the surface of the first component and the surface of the second component; and
attaching the surface of the first component to the surface of the second component with the sandwich layer therebetween, wherein the sandwich layer forms conductive areas between contacts of the first component and contacts of the second component and forms an insulator between the conductive areas.

2. The method of claim 1, wherein the attaching comprises reacting the sandwich layer with the contacts of the first and second components to form the conductive areas and reacting the sandwich layer with the insulating material of the first and second components to form the insulator.

3. The method of claim 1 or 2, wherein the sandwich layer comprises a conductive layer and wherein the attaching comprises reacting the sandwich layer with the insulating material of the first and second components to form the insulator.

4. The method of any of claims 1 to 3, wherein the sandwich layer comprises an electrically insulating layer and wherein the attaching comprises reacting the sandwich layer with the contacts of the first and second components to form the conductive areas.

5. The method of any of claims 1 to 4, wherein the first component comprises a plurality of through-vias extending from the surface to an opposed surface, each through-via electrically coupled to a contact at the surface and wherein the second component comprises a plurality of through-vias extending from the surface to an opposed surface, each through-via electrically coupled to a contact at the surface.

6. The method of claim 5, wherein the first component comprises a semiconductor wafer and the second component comprises a semiconductor chip.

7. The method of claim 5, wherein the first component comprises a semiconductor wafer and the second component comprises a semiconductor wafer.

8. The method of claim 5, wherein the first component comprises a semiconductor chip and the second component comprises a semiconductor chip.

9. The method of claim 5, wherein the first and second components both comprise semiconductor components and wherein the surface of the first component comprises an active-side surface and wherein the surface of the second component comprises an active-side surface.

10. The method of claim 5, wherein the first and second components both comprise semiconductor components and wherein the surface of the first component comprises and active-side surface and wherein the surface of the second component comprises a back-side surface.

11. The method of any of claims 5 to 10, wherein disposing a sandwich layer comprises depositing a layer of material on at least one of the surface of the first component and/or the surface of the second component.

12. The method of claim 11, wherein depositing a layer of material comprises depositing a layer of titanium.

13. The method of any of claims 5 to 12, wherein the sandwich layer comprises a redistribution layer.

14. The method of claim 13, wherein disposing the sandwich layer comprises:
depositing the sandwich layer on one of the surface of the first component or the surface of the second component; and
patterning the sandwich layer into the redistribution layer.

15. The method of any of claims 1 to 14, wherein the insulator formed between the conductive areas comprises an electrically-insulating, thermally-conducting material.

16. A method of stacking semiconductor chips, the method comprising:
providing a first semiconductor component having a surface that includes a plurality of exposed contacts separated by an insulating material, the first semiconductor chip further including a plurality of through-vias extending from the surface to an opposed surface and electrically contacting the contacts, the first semiconductor chip further including a sandwich layer formed at the surface in contact with the contacts and the insulating material;
providing a second semiconductor component having a surface that includes a plurality of exposed contacts separated by an insulating material, the second semiconductor chip further including a plurality of through-vias extending from the surface to an opposed surface and electrically contacting the contacts;
placing the surface of the first semiconductor component in contact with the surface of the second semiconductor component; and
interacting the sandwich layer with the contacts of the first semiconductor component and the second semiconductor component to form a conductive area that electrically connects contacts of the first semiconductor component with contacts of the second semiconductor component, and
simultaneously interacting the sandwich layer with at least one of the insulating material of the first component and/or the second component to form an insulator between the conductive areas.

17. The method of claim 16, wherein the sandwich layer comprises on of a titanium layer and a tantalum layer.

18. The method of claim 16 or 17, wherein the first and second semiconductor components comprise semiconductor wafers, the method further comprising dicing the semiconductor wafers after interacting the sandwich layer.

19. The method of any of claims 16 to 18, wherein interacting the sandwich layer comprises heating the sandwich layer at a temperature not greater than about 400 °C.

20. The method of any of claims 16 to 19, wherein placing the surface of the first semiconductor component in contact with the surface of the second semiconductor component comprises placing a front-side surface of the first semiconductor component in contact with a front-side surface of the second semiconductor component.

21. A method of making a semiconductor device, the method comprising:
forming active circuitry at a surface of a semiconductor wafer;
forming metallization over the active circuitry and in electrical contact with the metallization, the metallization and active circuitry forming a completed functional integrated circuit;
forming a final passivation layer over the metallization layer, the final passivation layer including openings to expose contact areas;
forming a plurality of through-vias through the semiconductor wafer, the through-vias electrically coupled to the contact areas; and
forming a blanket layer of conductive material over the final passivation layer and over the exposed contact area.

22. The method of claim 21, wherein the conductive material comprises titanium.

23. The method of claim 21 or 22, further comprising contacting the blanket layer of conductive material to a second semiconductor component.

24. The method of claim 23, further comprising singulating the semiconductor wafer into a plurality of dies after contacting the blanket layer of conductive material to the second semiconductor component.

25. The method of claim 23, further comprising singulating the semiconductor wafer into a plurality of dies before contacting the blanket layer of conductive material to the second semiconductor component.

26. A stacked semiconductor component comprising:
a first semiconductor chip having a surface that includes a plurality of contacts separated by an insulating material, the first semiconductor chip further including a plurality of through-vias extending from the surface to an opposed surface and electrically contacting the contacts;
a second semiconductor chip having a surface that includes a plurality of contacts separated by an insulating material, the second semiconductor chip further including a plurality of through-vias extending from the surface to an opposed surface and electrically contacting the contacts; and
a sandwich layer contacting the surface of the first semiconductor chip and the surface of the second semiconductor chip, the sandwich layer including conductive areas between contacts of the first component and contacts of the second component and an electrical insulator between the conductive areas.

27. The component of claim 26, wherein the sandwich layer comprises a conductive titanium compound at the conductive areas and a non-conductive titanium compound at the electrical insulator.

28. The component of claim 27, wherein the non-conductive titanium compound comprises a titanium silicate, oxide or oxynitride.

29. The component of claim 26, wherein the sandwich layer comprises a redistribution layer.

30. The component of claim 26, wherein the surface of the first semiconductor component comprises one of a front-side surface and a back-side surface and wherein the surface of the second semiconductor component also comprises a front-side surface.
